Europäisches Patentamt

(19) European Patent Office

Office européen des brevets

(11) EP 0 771 076 A1

(12) EUROPEAN PATENT APPLICATION

(43) Date of publication:
02.05.1997 Bulletin 1997/18

(51) Int. Cl.$^6$: H03L 7/20, H03L 7/18

(21) Application number: 96116451.4

(22) Date of filing: 14.10.1996

(84) Designated Contracting States:
DE FR GB IT

(30) Priority: 23.10.1995 JP 273916/95

(71) Applicant: NEC CORPORATION
Tokyo (JP)

(72) Inventor: Norimatsu, Hidehiko,
NEC Corp.
Tokyo (JP)

(74) Representative: Glawe, Delfs, Moll & Partner
Patentanwälte
Postfach 26 01 62
80058 München (DE)

(54) Frequency synthesizer

(57) A frequency synthesizer includes a modulator (141), a voltage controlled oscillator (VCO) (108), a bandpass filter (BPF) (109), a reference oscillator (104), and a control circuit (142). The modulator (141) outputs a modulated signal on the basis of a modulation signal and a local-oscillation frequency signal. The VCO (108) outputs a local-oscillation frequency signal having a variable frequency to the modulator (141) in accordance with an internal control signal. The BPF (109) filters a predetermined harmonic wave of the frequency of the local-oscillation frequency signal output from the VCO (108). The reference oscillator (104) outputs a reference frequency signal (132). The control circuit (142) detects the phase difference between a signal based on the output from the BPF (109) and a signal based on the reference frequency signal (132) from the reference oscillator (104) and outputs an internal control signal (135) to the modulator in accordance with the detected phase difference.

FIG. 1

EP 0 771 076 A1

## Description

### Background of the Invention

The present invention relates to a frequency synthesizer and, more particularly, to a frequency synthesizer used for a modulator.

A conventional frequency synthesizer of this type is used to output a local-oscillation (LO) frequency signal having a predetermined frequency.

In recent years, quadrature modulators are used in mobile telephones. A frequency synthesizer is used as a means for supplying a carrier wave to such a quadrature modulator. A local-oscillation frequency signal from the frequency synthesizer is supplied as a carrier wave to the quadrature modulator. The quadrature modulator also receives a modulation wave signal consisting of an I (In phase) component and a Q (Quadrant phase) component. The quadrature modulator modulates the carrier wave with the I-component modulation wave signal and the quadrant component signal of the carrier wave with the Q-component modulation wave signal. The quadrature modulator adds the I- and Q-component modulated wave signals to generate a modulated wave signal.

In this quadrature modulator, the frequency of the modulated wave signal is almost equal to that of the carrier wave, i.e., the local-oscillation frequency signal from the frequency synthesizer because the frequency of the modulation wave signal is very low with respect to the frequency of the carrier wave. When the modulated wave signal interferes with the frequency synthesizer, the frequency synthesizer cannot output a local-oscillation frequency signal having a predetermined frequency, thus posing a problem. One cause of this problem is an electrical connection between the quadrature modulator and the frequency synthesizer. The modulated wave signal from the quadrature modulator is input to the frequency synthesizer through electrical wiring, and therefore the frequency synthesizer steps out.

As a means for solving this problem, there may be proposed, for example, a circuit arrangement in which the frequency (to be referred to as a lock frequency hereinafter) of locking the frequency synthesizer is set different from the frequency of the modulated wave signal, i.e., a circuit arrangement in which the lock frequency is set different from the frequency of the local-oscillation frequency signal.

The circuit arrangement in which the lock frequency is set different from the frequency of the local-oscillation frequency signal has been used to reduce the tuning step width in a receiver. Such circuit arrangement is not actually employed in a modulator.

As a receiver having the circuit arrangement of this type, a synthesizer receiver described in Japanese Patent Laid-Open No. 60-111535 is known.

Fig. 2 shows the receiver of this reference.

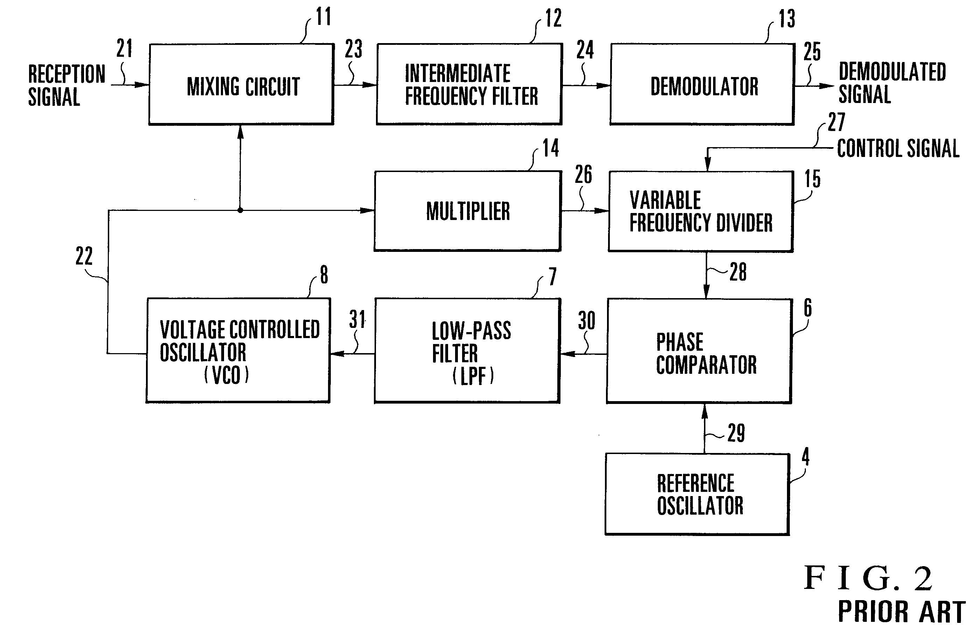

Referring to Fig. 2, a mixing circuit 11 receives a reception signal 21 and a local-oscillation frequency signal 22 from a voltage controlled oscillator (VCO) 8 and outputs an intermediate frequency (IF) signal 23. The intermediate frequency signal 23 is filtered through an intermediate frequency filter 12. An intermediate frequency signal 24 filtered through the filter 12 is demodulated by a demodulator 13 and output as a demodulated signal 25.

The local-oscillation frequency signal 22 from the VCO 8 is multiplied by a multiplier 14. A multiplied local-oscillation frequency signal 26 is frequency-divided by a variable frequency divider 15 at a frequency division ratio set by a control signal 27. The phase of a frequency-divided signal 28 is compared by a phase comparator 6 with the phase of a reference frequency signal 29 having a predetermined frequency from a reference oscillator 4. The phase difference detected by this phase comparison is input as a phase difference signal 30 to a low-pass filter (LPF) 7, thereby cutting off RF components. A phase difference signal 31 from which RF components are cut off is input to the VCO 8. The frequency of the local-oscillation frequency signal 22 output from the VCO 8 is determined in proportion to the level of the signal 31.

In the above arrangement, since the multiplier 14 and the variable frequency divider 15 are connected to the output of the VCO 8, the tuning step width can be set at a lower frequency than that of the reference frequency signal 29.

In the above receiver, although the tuning step width can be set at a lower frequency, the lock frequency, i.e., the frequency of the signal 28 input to the phase comparator 6 cannot be strictly made different from the frequency of the local-oscillation frequency signal 22 input to the mixing circuit 11.

More specifically, since the multiplier 14 is a nonlinear element, a plurality of harmonic waves of the local-oscillation frequency signal 22 are output from the multiplier 14 and are frequency-divided by the variable frequency divider 15. Since a signal having a frequency almost equal to that of the local-oscillation frequency signal 22 is present, a signal having a frequency almost equal to that of the local-oscillation frequency signal 22 may be input from the variable frequency diver 15 to the phase comparator 6. Therefore, the lock frequency becomes equal to the frequency of the local-oscillation frequency signal 22, and the local-oscillation frequency signal 22 from the VCO 8 cannot be stabilized to a predetermined frequency.

### Summary of the Invention

It is an object of the present invention to provide a frequency synthesizer capable of reliably making the lock frequency different from the frequency of a local-oscillation frequency signal.

In order to achieve the above object of the present invention, there is provided a frequency synthesizer comprising modulation means for outputting a modulated signal on the basis of a modulation signal and a local-oscillation frequency signal, first signal oscillation means for outputting a local-oscillation frequency signal having a variable frequency to the modulation means in accordance with an internal control signal, filter means for filtering a predetermined harmonic wave of the frequency of the local-oscillation frequency signal output from the first signal oscillation means, second signal oscillation means for outputting a reference frequency signal, and control means for detecting a phase difference between a signal based on the output from the filter means and a signal based on the reference frequency signal from the second signal oscillation means and outputting an internal control signal to the modulation means in accordance with the detected phase difference.

Brief Description of the Drawings

Fig. 1 is a functional block diagram of a frequency synthesizer according to an embodiment of the present invention; and
Fig. 2 is a functional block diagram of a conventional frequency synthesizer.

Description of the Preferred Embodiment

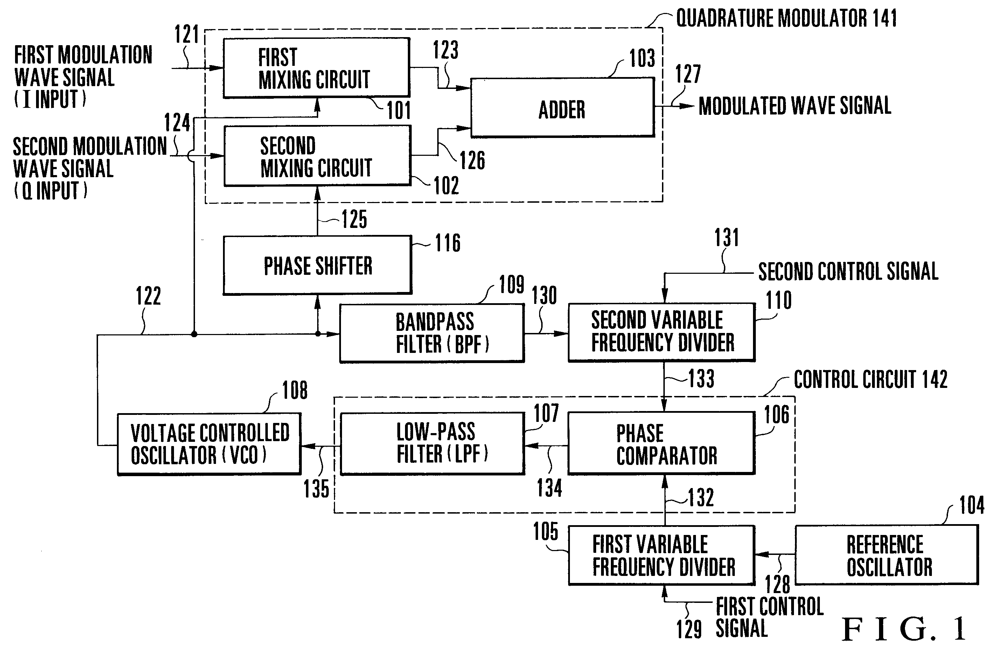

Fig. 1 shows a frequency synthesizer according to an embodiment of the present invention. Referring to Fig. 1, the frequency synthesizer comprises a first mixing circuit 101, a second mixing circuit 102, an adder 103, a reference oscillator 104, a first variable frequency divider 105, a phase comparator 106, a low-pass filter (LPF) 107, a voltage controlled oscillator (VCO) 108, a bandpass filter (BPF) 109, a second variable frequency divider 110, and a phase shifter 116. The first and second mixing circuits 101 and 102 and the adder 103 constitute a quadrature modulator 141 for receiving I- and Q-component modulation wave signals and a local-oscillation frequency signal and outputting a modulated wave signal. The phase comparator 106 and the low-pass filter 107 constitute a control circuit 142 for controlling the VCO 108. Note that the VCO 108, the BPF 109, and the control circuit 142 constitute a phase locked loop (PLL) circuit.

In the quadrature modulator 141, the first mixing circuit 101 receives a first modulation wave signal 121, i.e., the I-component input signal in the quadrature modulator and a local-oscillation frequency signal 122 from the VCO 108 and outputs an I-component modulated wave signal 123. The phase shifter 116 shifts the phase of the local-oscillation frequency signal 122 from the VCO 108 by 90°. The second mixing circuit 102 receives a second modulation wave signal 124, i.e., the Q-component input signal in the quadrature modulator and a signal 125 90° separated from the local-oscillation frequency signal from the phase shifter 116 and outputs a Q-component modulated wave signal 126. The I-component modulated wave signal 123 from the first mixing circuit 101 and the Q-component modulated wave signal 126 from the second mixing circuit 102 are added by the adder 103. The adder 103 outputs a modulated wave signal 127.

The reference oscillator 104 outputs a reference frequency signal 128 having a predetermined frequency. The reference frequency signal is frequency-divided by a first variable frequency divider 105 at a frequency division ratio set by a first control signal 129.

The local-oscillation frequency signal 122 from the VCO 108 is filtered through the BPF 109, so that a predetermined band component is passed, as will be described later. A filtered local-oscillation frequency signal 130 is frequency-divided by the second variable frequency divider 110 at a frequency division ratio set by a second control signal 131.

The phase of a signal 132 from the first variable frequency divider 105 is compared with that of a signal 133 from the second frequency divider 110 by the phase comparator 134 in the control circuit 142. The phase comparator 106 outputs a phase difference signal 134 representing the detected phase difference. RF components of the phase difference signal 134 are cut off by the LPF 107. The VCO 108 outputs a local-oscillation frequency signal 122 having a frequency proportional to the level of a phase difference signal 135 from which RF components are cut off.

The operation of the BPF 109 as the characteristic feature of the present invention will be described in detail.

The VCO 108 normally generates a local-oscillation frequency signal 122 proportional to the level of the phase difference signal 135 from the LPF 107 and a plurality of harmonic waves of the local-oscillation frequency signal 122. For example, when a signal having a frequency 2F which is a second harmonic wave of the plurality of harmonic waves of a frequency F of the local-oscillation frequency signal 122 is set to pass through the BPF 109, the frequency synthesizer is locked by the frequency of the output signal from the BPF 109, i.e., the frequency 2F twice the local oscillation frequency F.

At this time, frequency division ratios N and M of the first and second variable frequency dividers 105 and 110 are defined as follows:

$$N = FR/2FS \qquad (1)$$

$$M = 2F0/2FS = F0/FS \qquad (2)$$

where FR is the frequency of the reference frequency signal 128, F0 is the output frequency (the plurality of harmonic waves and the local-oscillation frequency signal 122 have frequencies which are integer multiples of the output frequency of an oscillation source) of this oscillation source of the VCO 108, and FS is the frequency switching step width in the first and second mixing circuits 101 and 102.

Since the frequency of the local-oscillation frequency signal 122 is different from the frequency for locking the frequency synthesizer, step-out of the local-oscillation frequency signal 122 from a predetermined value by the demodulated wave signal 127 having a frequency almost equal to that of the local-oscillation frequency signal 122 can be prevented.

In the above embodiment, the frequency synthesizer of the present invention is used as a quadrature modulator. The present invention is not limited to the quadrature modulator. The present invention is also applicable to any general modulator for generating a modulated wave signal having a frequency almost equal to that of the local-oscillation frequency signal, thereby obtaining the same effect as described above.

The present invention is further applicable to any circuit susceptible to a drawback of step-out of a local-oscillation frequency signal from a desired value due to the presence of a frequency almost equal to the frequency of the local-oscillation frequency signal.

In the above embodiment, a harmonic wave having the frequency 2F with respect to the local oscillation frequency F is set to pass through the BPF 109. However, the cutoff frequency of the BPF 109 is not limited to a specific value.

As has been described above, in the frequency synthesizer according to the present invention, since the frequency synthesizer is locked by a bandpass filter using a frequency which is a multiple of the frequency of the local-oscillation frequency signal, the frequency of the demodulated wave signal can be set different from the frequency for locking the frequency synthesizer. As a result, a local-oscillation frequency signal having a desired frequency can be output.

**Claims**

1. A frequency synthesizer characterized by comprising:

modulation means (141) for outputting a modulated signal (127) on the basis of a modulation signal (121, 124) and a local-oscillation frequency signal (122);
first signal oscillation means (108) for outputting a local-oscillation frequency signal having a variable frequency to said modulation means in accordance with an internal control signal (135);
filter means (109) for filtering a predetermined harmonic wave of the frequency of the local-oscillation frequency signal output from said first signal oscillation means;
second signal oscillation means (104) for outputting a reference frequency signal (130); and
control means (142) for detecting a phase difference between a signal (133) based on the output (130) from said filter means and a signal (132) based on the reference frequency signal from said second signal oscillation means and outputting an internal control signal to said modulation means in accordance with the detected phase difference.

2. A synthesizer according to claim 1, wherein said control means comprises:

a phase comparator (106) for detecting the phase difference between the signal based on the output (130) from said filter means and the signal based on the reference frequency signal from said second signal oscillation means and outputting a phase difference signal (134); and
a low-pass filter (107) for cutting off a high-frequency component included in the phase difference signal from said phase comparator and outputting the internal control signal.

3. A synthesizer according to claim 1, wherein the frequency of the local-oscillation frequency signal from said first oscillation means is substantially equal to that of the reference frequency signal from said second oscillation means.

4. A synthesizer according to claim 1, wherein said filter means comprises a bandpass filter.

5. A synthesizer according to claim 1, wherein said modulation means comprises a quadrature modulator.

6. A synthesizer according to claim 5, wherein said quadrature modulator comprises:

a first mixing circuit (101) for outputting an I (In phase)-component modulated wave signal on the basis of a first modulation wave signal (121) consisting of an I component and the local-oscillation frequency signal from said first oscillation means;
a second mixing circuit (103) for outputting a Q (Quadrant phase)-component modulated wave signal (126) on the basis of a second modulation wave signal (124) consisting of a Q component and a signal (125) 90° separated from the local-oscillation frequency signal from said first oscillation means; and
an adder (103) for adding the I-component modulated wave signal from said first mixing circuit and the Q-component modulated wave signal from said second mixing circuit and outputting a modulated wave signal.

7. A synthesizer according to claim 1, further comprising:

first variable frequency division means (105) for frequency-dividing the reference frequency signal from said second oscillation means in accordance with a first external control signal (129) and outputting a frequency-divided signal to said control means;

second variable frequency division means (110) for frequency-dividing the output signal from said filter means in accordance with a second external control signal (131) and outputting a frequency-divided signal to said control means, and

wherein said control means detects a phase difference between the frequency-divided signals from said first and second variable frequency division means and outputs an internal control signal.

8. A synthesizer according to claim 1, wherein said first signal oscillation means, said filter means and said control means constitute a phase locked loop (PLL) circuit which is locked by the harmonic wave of the frequency of the local-oscillation frequency signal form said first oscillation means.

9. A frequency synthesizer having a phase locked loop (PLL) circuit (108, 109, 142) for outputting a local-oscillation frequency signal (122), characterized in that said PLL circuit is locked by a harmonic wave of a frequency of the local-oscillation frequency signal.

10. A synthesizer according to claim 9, wherein said PLL circuit comprises filter means (109) for filtering a predetermined harmonic wave of the frequency of the local-oscillation frequency signal.

FIG. 1

FIRST MODULATION WAVE SIGNAL ( I INPUT ) — 121

SECOND MODULATION WAVE SIGNAL ( Q INPUT ) — 124

QUAORATURE MODULATOR 141

FIRST MIXING CIRCUIT — 101 — 123

SECOND MIXING CIRCUIT — 102 — 126

ADDER — 103 — 127 — MODULATED WAVE SIGNAL

PHASE SHIFTER — 116 — 125

BANDPASS FILTER ( BPF ) — 109 — 130

SECOND CONTROL SIGNAL — 131

SECOND VARIABLE FREQUENCY DIVIDER — 110 — 133

CONTROL CIRCUIT 142

VOLTAGE CONTROLLED OSCILLATOR ( VCO ) — 108 — 122

LOW-PASS FILTER ( LPF ) — 107 — 135 — 134

PHASE COMPARATOR — 106 — 132

FIRST VARIABLE FREQUENCY DIVIDER — 105

REFERENCE OSCILLATOR — 104 — 128

FIRST CONTROL SIGNAL — 129

EP 0 771 076 A1

**FIG. 2**
**PRIOR ART**

EP 0 771 076 A1

**European Patent Office**

## EUROPEAN SEARCH REPORT

Application Number

EP 96 11 6451

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| Y | PATENT ABSTRACTS OF JAPAN<br>vol. 018, no. 148 (E-1522), 11 March 1994<br>& JP-A-05 327493 (SONY CORP), 10 December 1993,<br>* abstract * | 1-10 | H03L7/20<br>H03L7/18 |
| Y | US-A-5 319 675 (OSAKA MASAHIKO) 7 June 1994<br>* figure 2 * | 1-10 | |

**TECHNICAL FIELDS SEARCHED** (Int.Cl.6)

H03L

The present search report has been drawn up for all claims

| Place of search | Date of completion of the search | Examiner |
|---|---|---|
| THE HAGUE | 24 January 1997 | Peeters, M |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document